# EUROPEAN PATENT SPECIFICATION

(11) **EP 3 422 429 B1**
(45) Date of publication and mention of the grant of the patent: **21.10.2020**
(21) Application number: 17382418.6
(22) Date of filing: 30.06.2017
(51) Int. Cl.: H01L 41/12, B81B 3/00, B82Y 15/00

(54) **MICROACTUATOR BASED ON BIMAGNETIC CORE/SHELL MICROWIRE HAVING ASYMMETRIC SHELL AND DISPLACEMENT METHODS**
MIKROAKTUATOR BASIEREND AUF BIMAGNETISCHEM KERN/HÜLLE-MIKRODRAHT MIT ASYMMETRISCHER HÜLLE SOWIE BEWEGUNGSVERFAHREN
MICRO-ACTIONNEUR À BASE DE MICRO-FIL COEUR/ÉCORCE BIMAGNÉTIQUE AVEC ÉCORCE ASYMÉTRIQUE ET PROCÉDÉS DE DÉPLACEMENT

(43) Date of publication of application: 02.01.2019
(73) Proprietor: Consejo Superior de Investigaciones Científicas (CSIC), 28006 Madrid (ES); IMMANUIL KANT BALTIC FEDERAL UNIVERSITY (IKBFU), Kaliningrad 236041 (RU)
(72) Inventor: VAZQUEZ VILLALABEITIA, Manuel, 28049 MADRID (ES); ELKAMMOUNI, Rhimou, 28049 MADRID (ES); RODIONOVA, Valeria, 236041 Kaliningrad (RU); PEROV, Nikolai, 236041 Kaliningrad (RU); CHICHAY, Ksenia, 236041 Kaliningrad (RU); BARABAN, Irina, 236041 Kaliningrad (RU)
(74) Representative: Pons

(56) References cited:
- DE-C1- 19 510 250
- IKUNO T ET AL: "Thermally driven nanomechanical deflection of hybrid nanowires", APPLIED PHYSICS LETTERS, vol. 87, no. 21, 213104, 14 November 2005 (2005-11-14), XP012076580, ISSN: 0003-6951, DOI: 10.1063/1.2133919
- HONDA T ET AL: "Fabrication of magnetostrictive actuators using rare-earth (Tb,Sm)-Fe thin films", JOURNAL OF APPLIED PHYSICS, vol. 76, no. 10, 15 November 1994 (1994-11-15), pages 6994-6999, XP000508876, ISSN: 0021-8979, DOI: 10.1063/1.358067
- TORREJÓN J ET AL: "Electroplated Bimagnetic Microwires: From Processing to Magnetic Properties and Sensor Devices", JOURNAL OF THE MINERALS, METALS & MATERIALS SOCIETY, vol. 65, no. 7, 26 April 2013 (2013-04-26) , pages 890-900, XP035350875, ISSN: 1047-4838, DOI: 10.1007/S11837-013-0614-3 [retrieved on 2013-04-26]

## Description

### OBJECT OF THE INVENTION

The overall objective of the invention is a microactuator based, or making use, of a hybrid or composite active element.

A particular feature is the asymmetric character of the composite active element of the microactuator. It takes advantage of the particular response to an applied magnetic field of a active element formed by a multilayer bimagnetic coated core/shell microwire where each magnetic phase exhibits different magnetostrictive character. The active phases are: i) an internal metallic magnetostrictive core, and ii) an external coating metallic magnetostrictive shell.

A relevant concept is that the external shell is asymmetric in the sense that it covers only partly the internal core.

The microactuator based on the bimagnetic coated core/shell microwires with asymmetric external shell can be used to control the positioning and manipulation of nano to micro magnetic and nonmagnetic objects in two modes namely, contact and non-contact modes. Its application covers areas as physics, chemistry and nanotechnology, but also in biochemistry, biology and pharmaceutics where the physical touch are often harmful to living cultures.

Distinctive features of the microacuator based on the bimagnetic coated core/shell microwires with asymmetric external shell from similar devices, such as magnetic tweezers, are:
i) the possibility to reach absence of any residual or remanent field for microwires with selected alloy composition, which has an additional influence on the manipulated object and reduces the displacement accuracy; and
ii) a larger size range of the manipulated objects (up to tens of micrometres) and larger spatial workspace.

### PRIOR ART

The accurate manipulation of miniaturized objects is essential for the development of novel advanced technologies at the nano and microscales.

Nowadays, advanced devices for such manipulation make use of different instruments including optical and magnetic tweezers, piezoelectrics, computer disk drive heads or atomic force microscopy (AFM) [K.C. Neurman, A. Nagy, "Single-molecule force spectroscopy: optical tweezers, magnetic tweezers and atomic force microscopy", Nature Methods, Vol. 5, 6, (2008) 491-505].

Each of these systems provides the unique opportunities for control and study of nano- and micro- objects. For example, AFM allows one to manipulate objects of atomic size and image them up to a few micrometres. The forces that could be applied to the objects range from 10 to 1000 pN [D. Dulin, J. Lipfert, M. Ch. Moolman, N. H. Dekker, "Studying genomic processes at the single-molecule level: introducing the tools and applications", Nature Review Genetics, Vol. 14, 1, (2013) 9-22].

The optical trap can capture the objects ranging in size from 0.25 to 10 µm [K. Svoboda, S. Block, "Optical trapping of metallic Raleigh particles", Optic letters 19, (1994) 930-932] and act with force up to 100 pN [R. Litvinov, H. Shuman, J. Benette, J. Weisel, "Binding strength and activation state of single fibrinogenintegrin pairs on living cells", Proceedings of the National Academy of Sciences 99 (2002), 7426-7431].

However, optical tweezers can be used only for partially transparent particles in a liquid. Some types of mechanical microactuators use different physical effects such as electromagnetism, electrostatics, piezoelectric force and shape memory effect to generate the movement and control the gripping force. The microactuator, based on piezoelectric effect, can achieve a force of 20 mN to grab and move the objects [GeBner, T., "Recent Progress of Microactuators" in: Proc. 7th Int. Conf. New Actuators (Bremen, 19-21 June 2000) Bremen: ASCO-Druck 2000, pp 62-70]. Shape memory alloy microactuators allow to manipulate objects up to 180 micrometres size with a maximum gripping force of 17 mN [Just, E. et al, "SMA Microgripper with Integrated Antagonism", in: Proc. Transducers '99, 10th Int. Conf. Solid-State Sensors and Actuators (Sendai, Japan, June 7-10 1999) S. 1768-1771]. Its state can be controlled by electrical heating above the phase transition temperature.

Magnetic tweezers have several advantages as compared with other types of tweezers: no restrictions on transparency and the particle size, as in optical tweezers, and they allow the operation in various environments (gas, liquid, vacuum) [J. Zlatanova, K. van Holde, "Single-Molecule Biology: What Is It and How Does It Work", Molecular Cell 24, 317-329, November 3 (2006), 317-329]. However, in some cases the presence of residual field does not allow to stop the influence on the magnetic particle immediately after current interruption.

A different family of devices makes use of hybrid elements composed of units with specific different response to given agent (e.g. magnetic field). Microactuators are commonly designed in a planar configuration. One of such microactuators is a bilayer system consisting of magnetostrictive and non-magnetic counter layers. The operation principle is based on the magneto-elastic effect (e.g., the sensitivity of the permeability of the bilayer to bending and temperature). The sensitivity, determined as the ratio of the permeability to its initial value, reaches 70%. Such bilayer system can be used as a continuous non-disturbing monitoring of blood pressure changes [H. Pfutzner, E. Kaniusas, J. Kosel, L. Mehnen, T. Meydan, M. Vazquez, M. Rhon, A.M. Merlo, and B. Marquardt, Sens. Actuators 129, 154 (2006)].

Alternative actuators make use of cylindrical symmetry and profit of the uniaxial directional anisotropy. Current magnetic tweezers based on non-magnetic microwires systems allow for the capture of nano- and micro- objects via the magnetic field generated by the electric currents flowing through these wires. The position of the manipulated objects is thus controlled by changing in a controlled way the value of the current. Applied force to the manipulated objects reaches 3 pN [V. Bessalova, N. Perov, V. Rodionova, New approaches in the design of magnetic tweezers-current magnetic tweezers, Journal of Magnetism and Magnetic Materials (2016); doi:10.1016/j.jmmm.2016.03.038].

Amorphous magnetic microwires exhibit an outstanding magnetic behavior when submitted to longitudinal magnetic fields which is a consequence of their amorphous structure and the mechanical stresses quenched-in during their fabrication by ultrarapid solidification. Microwires made of high positive magnetostriction alloy (e.g., FeSiB) are relevant because of their bistable magnetic behavior characterized by a giant Barkhausen jump originating in the propagation of a single domain wall. Those with negative magnetostriction (e.g., CoSiB) exhibit nearly constant susceptibility until reaching magnetic saturation and reduced coercivity and remanence. In turn, amorphous microwires with vanishing magnetostriction (e.g., CoFeSiB and CoFeNiSiB) show very high susceptibility and giant magneto impedance effect. Description and analysis of the general properties of glass-coated microwires can be found elsewhere [A. Zhukov and V. Zhukova, "Magnetic Properties and Applications of Ferromagnetic Microwires with Amorphous and Nanocrystalline Structure" (Hauppauge, NY: Nova Science Publishers, Inc., 2009), 162].

A novel family of bimagnetic multilayer microwires with additional properties arising from the presence of the two magnetic phases was recently introduced. They contain an internal magnetic nucleus and external magnetic shell. Eventually, an intermediate insulating glass layer is present (e.g., in the case of glass-coated based bimagnetic microwires). Such bimagnetic microwires are fabricated by combined ultrarapid solidification, sputtering and electrodeposition techniques [K. Pirota, M. Hernandez-Velez, D. Navas, A. Zhukov and M. Vazquez, Adv. Funct. Mater. 14, 266 (2004); J. Torrejón, G. Infante, G. Badini-Confalonieri, K.R. Pirota and M. Vazquez, "Electroplated Bimagnetic Microwires: From Processing to Magnetic Properties and Sensor Devices", The Journal of The Minerals, Metals & Materials Society (TMS), (2013) DOI: 10.1007/s11837-013-0614-3].

The document DE19510250C1 discloses an actuator with an electrical connection and at least one conductor element having electromechanical transducer, wherein a) the conductor element consists of a magnetostrictive material or b) the conductor element is constructed layered and at least one first layer consists of a magnetostrictive material.

In the document of Ikuno T. et al.: "Thermally driven nanomechanical deflection of hybrid nanowires", App. Phys. Lett., 87, 213104 (2005), the authors observed thermally induced nanomechanical deflection of a hybrid inorganic nanowire (NW) synthesized by pulsed-laser deposition, the structure of which is a carbon nanotube template sandwiched by aluminum oxide and tungsten oxide thin layers. The hybrid NW was gradually bent at a specimen temperature ranging from room temperature to 800 °C, due to the different coefficients of thermal expansion of the coated layers.

In the document of Honda T. et al.: "Fabrication of magnetostrictive actuators using rare-earth (Tb,Sm)-Fe thin films", Journal of Applied Physics 76, 6994 (1994), a new concept is proposed for the microactuation based upon magnetostriction. Magnetostrictive bimorph cantilever actuators and a traveling machine, composed of the magnetostrictive amorphous Tb-Fe and Sm-Fe thin films on a polyimide substrate, were fabricated. These actuators moved without power supply cables. The features thereof suggest that magnetostriction is useful as the driving force of the microactuator.

Bimagnetic multilayer microwires have been proposed earlier where the external magnetic shell covers completely the internal nucleus [WO2007/054602; WO2011/009971].

### BRIEF DESCRIPTION OF THE INVENTION

It is a first object of the present invention a microactuator based on bimagnetic coated core/shell microwires with asymmetric external shell having at least one composite one-dimensional active element which comprises:
- an internal metallic magnetostrictive core;
- an external coating metallic magnetostrictive shell.

The materials of the internal metallic magnetostrictive core and the external coating metallic magnetostrictive shell display either opposite magnetostriction sign or the same magnetostriction sign with different values of the respective magnetostriction coefficient.

The characterizing feature of the microactuator is that the external coating metallic magnetostrictive shell covers asymmetricaly only partly the internal core.

Cross-section asymmetry is the essential feature.

The internal metallic magnetostrictive core and the external coating metallic magnetostrictive shell may be coaxial depending on the geometrical configuration of the active element.

Through the present description, the internal metallic core will be also referred to as nucleus.

In a preferred embodiment, the materials of the internal metallic magnetostrictive core and the external coating metallic magnetostrictive shell have the same magnetostriction sign with values of the respective magnetostriction coefficient which differ by at least a factor of 10, more preferably the materials of the internal metallic magnetostrictive core and the external coating metallic magnetostrictive shell have the same magnetostriction sign with magnetostriction coefficient values differing in a factor ranging from 10 to 1000.

The at least one composite one-dimensional active element of the microactuator presents a geometrical configuration selected from cylindrical, spheroidal and ellipsoidal, preferably the at least one composite one-dimensional active element is cylindrical and the external coating metallic magnetostrictive shell covers concentrically and asymmetrically only partly the internal core.

The relevant dimension may vary depending from the selected geometrical configuration: diameter in cylindrical configuration and major axis in ellipsoidal configuration.

In another preferred embodiment, the internal metallic magnetostrictive core is coated by an insulating glass cover and the external coating metallic magnetostrictive shell covers only partly asymmetricaly the internal metallic magnetostrictive core with the insulating glass cover.

In further preferred embodiments:
- the internal metallic magnetostrictive core is formed by a metallic ferromagnetic alloy and has a relevant dimension ranging from 0.6 to 30 µm
- the metallic ferromagnetic alloy forming the internal metallic magnetostrictive core has amorphous structure and comprises:
   - 65% to 85% in atomic percentage of magnetogen elements selected from Fe, Co and Ni and combinations thereof.
   - 15% to 35% in atomic percentage of metalloid elements selected from Si, B and C.
- the metallic ferromagnetic alloy forming the internal metallic magnetostrictive core additionally comprises other non-magnetic elements selected from Al, Cu, Nb, Mn, Cr, Mo and combinations thereof in an amount less than 5% in atomic percentage to keep the amorphous structure of the alloy.

In embodiments including an insulating glass cover, its thickness ranges from 2 µm to 30 µm.

Regarding the external coating metallic magnetostrictive shell, in one preferred embodiment it is formed by a metallic ferromagnetic alloy and has a thickness ranging from 0.03 to 5 µm.

In reference to the characterizing feature, the external coating metallic magnetostricitve shell covers the internal core in a range from 20% to 80% of its outer surface. In further preferred embodiments the coverage of the internal core by the external coating metallic magnetostricitve shell ranges from 30% to 70%, more preferably from 40% to 60% and even more preferably 50%.

The metallic ferromagnetic alloy forming the external coating metallic magnetostrictive shell comprises magnetogen elements selected from Fe, Co and Ni and combinations thereof. Preferably, the metallic ferromagnetic alloy of the external coating metallic magnetostrictive shell is a metallic alloy based on CoFe elements.

In another further preferred embodiment, a metallic nanolayer is located on the internal metallic magnetostrictive core, whereon the external coating metallic magnetostrictive shell is deposited. Alternatively, the metallic nanolayer is located on the insulating glass cover whereon the external coating metallic magnetostrictive shell is deposited.

Preferably, the metallic nanonolayer is made of a noble metal, more preferably the noble metal is gold.

Another object of the invention is the use of the microactuator based on bimagnetic coated core/shell microwires with asymmetric external shell either with magnetic objects or with non magnetic objects.

The interaction with magnetic objects includes:
- approaching the microactuator to the magnetic object
- applying an external magnetic field to the active element of the microactuator
- capture of the stray field generated at the end of the active element of the microactuator by the magnetic object
- bending of the active element of the microactuator
- displacement in two or three dimensions of the magnetic object captured by the stray field at the end of the active element.

The interaction with non magnetic objects includes:
- contacting the microactuator with the non magnetic object
- applying an external magnetic field to the active element of the microactuator
- bending of the active element of the microactuator
- mechanical displacement in two or three dimensions of the non magnetic object

### BRIEF DESCRIPTION OF THE FIGURES

**Figure 1****:** Scheme of the bimagnetic microwire with asymmetric external shell (a), and its bending under the action of magnetic field, H (b). Arrows in the microwire denote the magnetostrictive bending stress.
**Figure 2****:** Scheme of the bimagnetic microwire, which bends under the action of magnetic field, H, generating (a) a magnetic force on a magnetic nanoparticle (non-contact mode), (b) a mechanical force on a non-magnetic object (contact mode)
**Figure 3****:** Scheme of the microactuator with tri-microwire design to control the position of the manipulated object in two dimensions.
**Figure 4****:** SEM-images of FeSiB glass-coated microwire coated asymmetrically by a sputtered shell (a) with detail of the shell's thickness (b) (using Ultra-high resolution low-vacuum FEI Nova NanoSEM 230 microscope); visualization of the core/shell microwires with asymmetric external shell (c) and (d): the glass is the illuminated brighter side and the shell is dark side of the image (using SEM JEOL).
**Figure 5****:** Composed image showing the bending of different microwires under increasing applied magnetic field up to a maximum of 39788.7 A/m (500 Oe): single-phase FeSiB glass-coated microwire (left), and biphase microwires with Co (middle) and FeNi (right) external shells.

### DETAILED DESCRIPTION OF THE INVENTION

The proposed invention is a microactuator based on bimagnetic coated core/shell microwires with asymmetric external shell as described above for the final manipulation of nano- and micro- objects.

Their main characteristics involve:
i) Biphase character,
ii) different magnetostriction sign or different magnetostriction coefficient
iii) It profits of the different response of each phase to a given external agent, such as a magnetic field
iv) The asymmetric partial coating of the external shell confers the microactuator specific differential characteristics.

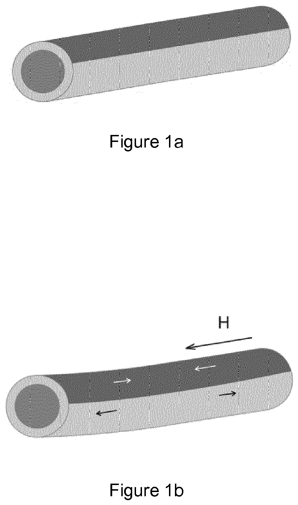

Particularly, the external coating metallic magnetostictive shell covers only partly the internal magnetostrictive core, which is the basic concept of the new approach introduced in this patent application. The final objective searched by the partial coating is to introduce a particular asymmetry in the microwire with given geometry (Fig. 1a).

The main active element of the proposed microactuator are thus the bimagnetic coated core/shell microwires with asymmetric external shell. The ferromagnetic materials of the metallic core and external shell exhibit opposite sign or eventually different values of the magnetostriction coefficient (i.e., positive, or negative, irrespectively), which enhances significantly the magnetoelastic response of the bi-phase microwire. Consequently, under an applied longitudinal magnetic field, the internal core will elongate while the external shell will shrink, or vice versa. This leads to the bending of the microwire that is, to an effective shift of the microwire end as schematically shown in Fig. 1b.

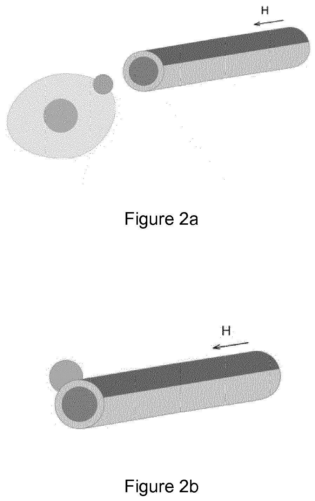

It is possible to manipulate the positioning of the microwire end by controlling the applied magnetic field. There are two different modes of manipulation depending on the magnetic nature of the objects:
I) To capture the magnetic nano- and micro- objects by the stray fields created at the end of microwire and move the objects for the required distance (Fig. 2a, non-contact mode);
II) To manipulate the position of non-magnetic objects by direct mechanical motion of the microwire end (Fig. 2b, contact mode).

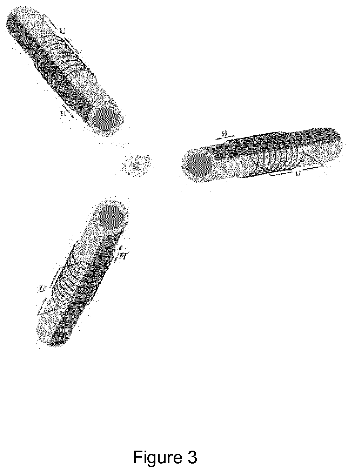

The manipulation of a magnetic nano- or micro magnetic object in two dimensions (X and Y axis) can be also achieved making use of a tri-microwire design (Fig. 3). Here, the stray field generated at the end of each magnetized asymmetric microwire is tailored by the current of a surrounding tiny coil. The magnetized microwire actually acts as a small electromagnet, and the appropriate control of stray fields from each microwire determines the total stray field in the region between microwires.

Thus, the microactuator based on the bimagnetic coated core/shell microwires with asymmetric external shell can be used in two modes - non-contact and contact - that allows one to apply it not only in such areas as physics, chemistry and nanotechnologies, but also in biochemistry, biology and pharmaceutics where the physical touch are often harmful to living cultures.

One distinctive feature of the microacuator based on the bimagnetic coated core/shell microwires with asymmetric external shell, from its direct analogue (magnetic tweezers), is the possibility to achieve absence of any residual field, provided that specific composition and parameters of the biphase microwire are carefully selected. Residual magnetic field has an additional influence on the manipulated object and reduces the displacement accuracy. Additionally, residual fields require a larger size range of the manipulated objects (up to tens of micrometres) and larger spatial workspace.

The preparation of one of the embodiments of the microactuator is carried out by two alternative processes.

The first one is:
a1) Ultrarapid solidification process of fabrication of the internal magnetic core coated by insulating glass-cover (modified Taylor-Ulitovsky method) (e.g. Pyrex).
a2) Sputtering of a metallic nanolayer onto the mentioned glassy cover
a3) Electrodeposition of a metallic ferromagnetic external shell coaxial with the core. This external shell or concentric microtube has been developed previously to cover symmetrically and completely the internal core. The invention consists here to electrodeposit the external shell covering only partially the core, having a nearly axial shape as indicated schematically in Fig. 1a. In order to achieve the partial coating of the internal core, a mask is employed which determines the shape of the external shell. This first alternative allows the growth of a micrometric thick external shell. A challenge is the proper coating of the mask.

The second one is:
b1) Ultrarapid solidification process of fabrication of the internal magnetic core coated by insulating glass-cover (modified Taylor-Ulitovsky method) (e.g. Pyrex).
b2) Sputtering of the external magnetic metallic shell directly onto the mentioned glassy cover. The invention consists here to sputter the external shell covering only partially the core, having a nearly axial shape as indicated schematically in Fig. 1a. To achieve that goal the ends of the single phase microwire, carefully cleaned in alcohol, are fixed to the holder inside the chamber allowing only the sputtering on the partial lateral side of the microwire. This second alternative allows for the growth of hundreds of nanometer thick external shell. A challenge here is the limited thickness of the external shell.

In both cases, the composition of the internal core and external shell is designed to exhibit different magnetic behavior namely, different signs of magnetostriction constant or same magnetostriction sign but different values of magnetostriction coefficient. That promotes the required bending of the microwire when submitted to applied magnetic field as schematically shown in Fig. 1 b.

To avoid remanent stray fields, only a vanishing or negative magnetostriction core can be employed using the design in Fig. 3 where the magnetic state is controlled by the current in the tiny coils.

### EMBODIMENTS OF THE INVENTION

In the following examples the preparation of the microactuator with specific details is described. First, the preparation of the bimagnetic coated core/shell microwires with asymmetric external shell is described.

As previously indicated, for the two alternatives the internal core consists of an amorphous ferromagnetic glass-coated microwire prepared by quenching and drawing technique (modified Taylor-Ulitovsky method).

For the final purpose of the invention, one important magnitude is the magnetostriction which is determined mainly by the alloy composition. In these embodiments, three specific alloys with different magnetostriction constant are considered:
a) Fe₇₅Si₁₅B₁₀ (with elevated and positive magnetostriction, λ_{S} ≈ +30x10⁻⁶)
b) (Co_{0.94}Fe_{0.06})₇₅Si₁₅B₁₀ (with vanishing magnetostriction, λ_{S} ≈ ±0.1x10⁻⁶), and
c) Co₇₅Si₁₅B₁₀ (with moderate negative magnetostriction, λ_{S} ≈ -1x10⁻⁶).

### Bimagnetic coated core/shell microwire with asymmetric external shell manufacturing procedure

The manufacturing of the external magnetic shell requires its asymmetric covering of the internal magnetic phase. There are two alternative ways:
The first one comprises first the sputtering of a metallic nanolayer of gold (20 to 50 nm thick) followed by the electrodeposition of the external shell. The general procedure of fabrication of the external magnetic shell is explained in detail for example in M. Vazquez, "Advanced Magnetic Microwires" in: Handbook of Magnetism and Advanced Magnetic Materials, vol. 4 Wiley, Chichester, UK, (2007) pp. 2193. Importantly for the purpose of the invention is the magnetostrictive character of the external shell which microstructure is typically polycrystalline. Two kinds of external shells with different magnetic character are used for these embodiments:
Fe₁₉Ni₈₁ (with ultrasoft magnetic character and vanishing magnetostriction, λ ≈ ±0.1x10⁻⁶), and Co or Co₉₀Ni₁₀ (with magnetically harder character and negative magnetostriction coefficient λ ≈ -30 x10⁻⁶).

The inventive feature of the manufacturing procedure is the suitable mask process to cover the external part of the nanolayer of gold that allows for the electroplating of asymmetrical external shell. Such Au nanolayer serves as an electrode for the subsequent electroplating growth of the external second magnetic phase. Magnetically soft FeNi alloys and magnetically hard Co or CoNi alloys (saturation magnetostriction of the latter also has a variety of values) are selected for the electrodeposited ferromagnetic shell. Using electrodeposition it is possible to prepare both fully and partially covered microwire. For manufacturing of bimagnetic coated core/shell microwires with asymmetric external shell by electrodeposition, the protective layer is applied, which covers 50% of the microwire external surface along the axis. This layer avoids the deposition on the covered part of microwire thereby allowing the formation of a partially applied shell. The protective layer can be removed after electrodeposition. The thickness of ferromagnetic shell is controlled by electrodeposition time and current density and ranges from 0.1 to 5 µm.

The second alternative process to grow the asymmetric external shell consists of the straightforward sputtering of the metallic shell once the glass-coated microwire was produced. The sputtering process has been performed using a magnetron sputtering. To prepare bimagnetic coated core/shell microwires with asymmetric external shell using magnetron sputtering, first the ends of the amorphous ferromagnetic single phase microwires, previously cleaned in alcohol, are fixed on a holder which is subsequently put in the sputtering chamber. The fixed ends help to have a good contact between microwire and holder, so that only 50% of the microwire external surface is sputtered. Then using the targets of suitable magnetostrictive materials sputtering is performed to grow a 30 to 2000 nm thick film on the surface of the microwire.

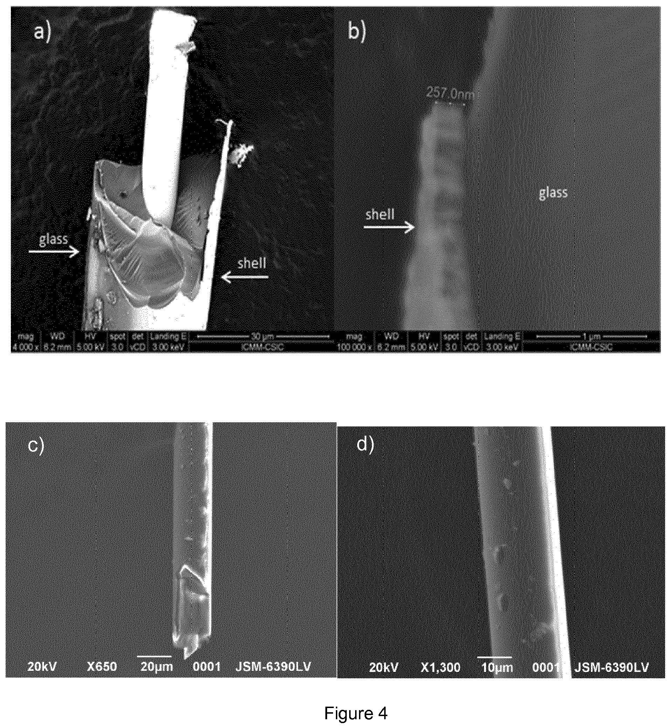

In figures 4 a glass-coated microwire partially covered by a Fe₁₉Ni₈₁ sputtered shell 260 nm thick can be observed.

### Use of the microactuator

A bimagnetic coated core/shell microwire with asymmetric external shell is selected with the following characteristics:
Nucleus: FeSiB (soft character and positive magnetostriction coefficient) and FeCo-based or FeCoNi-based (ultrasoft character and vanishing magnetostriction coefficient) glass-coated microwires with diameters of the metallic nucleus ranging from 1 to 30 µm and total diameter of the glass-coated microwire from 5 to 60 µm.
Shell: FeNi (magnetically ultrasoft with near zero magnetostriction coefficient), and Co and CoNi (magnetically harder with negative magnetostriction coefficient) shell with thickness from 0.03 to 5 µm coaxially and asymmetrically covering partially the nucleus.

So, the total diameter of bimagnetic wire is from 5 to 70 µm.

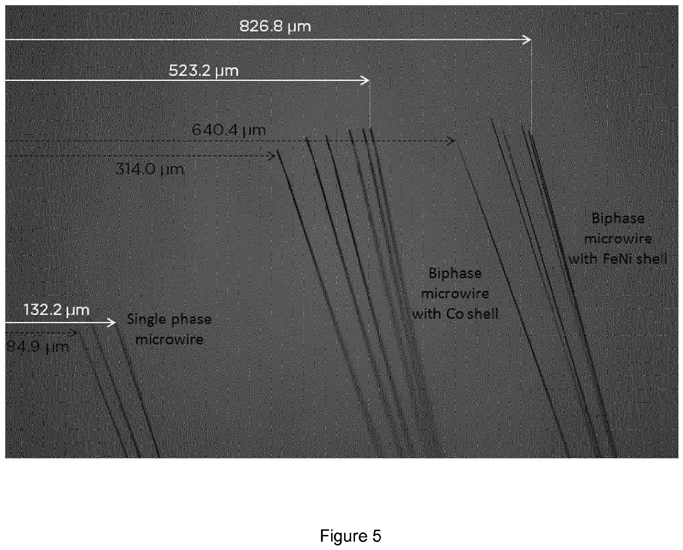

The microwires - single-phase, and biphase partially covered by FeNi, Co or CoNi asymmetric external shells have been submitted to applied field along the longitudinal direction, that is, parallel to the microwire axis. As an example, Fig. 5 depicts the bending effect under variable applied fields up to 39788.7 A/m (500 Oe) for a particular composition of metallic core of single phase microwire and two compositions of the shell (Co and FeNi). The Fe_{77.5}B₁₅Si_{7.5} alloy was considered for the metallic nucleus of single phase microwire with diameter of 10.2 µm, and 25 µm for the total diameter. The thickness of partially covering external shell is the same for Co and FeNi, that is, 300 nm. The length of microwires was 2 cm. The left positions (see Figure 5), indicated by the black dashed arrows, correspond to the situation without applied magnetic field. The white arrows to the right indicate the position of microwire at maximum magnetic field of 39788.7 A/m (500 Oe) applied along the microwire axis. All the positions of microwires between black dashed and white arrows are related to the intermediate values of the magnetic fiend ranging from 0 to 39788.7 A/m (500 Oe). As schematically indicated in Figure 1b the microwires undergo a bending deformation which is proportional to the amplitude of the DC axial magnetic field.

From Figure 5 it can be concluded that all the microwires (single and biphase) are bent by applying a magnetic field. The bending properties of the single phase microwire are associated with non-uniform distribution of the internal stresses that arise during the manufacturing procedure and due to the different values of the thermal expansion coefficients for glass and metal. These non-uniform distributed stresses cause that the microwire undergoes different deformations at local positions of the microwire. The amplitude of bending in the case of single phase microwire is 47.3 µm at maximum applied magnetic field of 39788.7 A/m (500 Oe). The presence of the external shell, the magnetostriction coefficient of which is different, leads to the additional bending force, and hence, to larger bending deformation.

The magnetostriction coefficients for FeNi and Co are different: nearly zero for FeNi and negative for Co. As observed in Figure 5 in case of Co external shell, the bending deformation amplitude, 209.2 µm, is larger than the one, 186.4 µm, observed for the biphase microwire with FeNi shell. This fact allows one to conclude that the enhanced deflection effect is originated by the combination of the positive magnetostriction of the metallic nucleus and the negative magnetostriction of the external shell.

The microactuator based on bimagnetic coated core/shell microwires with asymmetric external shell has the following original aspects.

### 1. The absence of the residual field:

The use of soft magnetic materials gives the possibility to avoid or at least significantly reduce in a controlled manner the otherwise strong residual stray field generated by hard magnetic materials at remanence which has an additional influence on the manipulated object and reduces the displacement accuracy. In the case of amorphous ferromagnetic alloy, based on Fe, with positive magnetostriction coefficient, the microwire is magnetically bistable, that means that only two magnetic states are stable corresponding to the two axial directions along the microwire axis. The value of the magnetic field required for switching of magnetic state (reversal magnetization occurs by a single giant Barkhausen jump) is very small (e.g., down to 20 A/m).

In turn, when the metallic core of the microwire is made of an alloy material with nearly zero magnetostriction (CoFe, or CoFeNi-based alloys) or negative magnetostriction (Co-based alloys), the reversal magnetization process has a nearly non-hysteretic behavior. This fact allows one to avoid the appearance of any strong residual field, which appears in the case of magnetic tweezers using permanent magnets, and enhance the precision of the microactuator based on bimagnetic coated core/shell microwires with asymmetric external shell.

### 2. Two operating modes: non-contact and contact

The microactuator based on bimagnetic coated core/shell microwires with asymmetric external shell can be used in two operating modes.
a) Non-contact mode: Magnetic objects can be captured by the stray fields generated at the end of the microwire when it is magnetized. Then, the captured magnetic objects, sticking at the end or located within a certain distance from the microwire can be displaced following the end of the microwire while bending. The magnitude of bending is controlled by the value of the external magnetic field applied along the microwire axis.
   This mode can be used for the control of biological objects through attached specially functionalized magnetic particles, when the direct mechanical contact can be harmful to living cultures.
**b)** Contact mode: The microactuator based on bimagnetic coated core/shell microwires with asymmetric external shell also allows manipulating non-magnetic objects. In this case, the object can be displaced mechanically when the movement of the microwire end directly causes the motion of the manipulated object.

## Claims

1. Microactuator based on bimagnetic coated core/shell microwires **characterized in that** it comprises an asymmetric external shell having at least one composite one-dimensional active element which comprises:
- an internal metallic magnetostrictive core
- an external coating metallic magnetostrictive shell the materials of said internal metallic magnetostrictive core and said external coating metallic magnetostrictive shell displaying either opposite magnetostriction sign or the same magnetostriction sign with different values of the respective magnetostriction coefficient,
and wherein the external coating metallic magnetostrictive shell covers asymmetrically only partly the internal core.

2. Microactuator based on coated core/shell microwires with asymmetric external shell according to claim 1, wherein the materials of the internal metallic magnetostrictive core and the external coating metallic magnetostrictive shell have the same magnetostriction sign with values of the respective magnetostriction coefficient which differ by at least a factor of 10.

3. Microactuator based on coated core/shell microwires with asymmetric external shell according to claim 2, wherein the materials of the internal metallic magnetostrictive core and the external coating metallic magnetostrictive shell have the same magnetostriction sign with magnetostriction coefficient values differing in a factor ranging from 10 to 1000.

4. Microactuator based on coated core/shell microwires with asymmetric external shell according to anyone of claims 1 and 3, wherein the at least one composite one-dimensional active element presents a geometrical configuration selected from cylindrical, spheroidal and ellipsoidal.

5. Microactuator based on coated core/shell microwires with asymmetric external shell according to claim 4, wherein the at least one composite one-dimensional active element is cylindrical and the external coating metallic magnetostrictive shell covers concentrically and asymmetrically only partly the internal core.

6. Microactuator based on bimagnetic coated core/shell microwires with asymmetric external shell according to anyone of claims 1 to 5 wherein the internal metallic magnetostrictive core is coated by an insulating glass cover and the external coating metallic magnetostrictive shell covers only partly asymmetrically the internal metallic magnetostrictive core with the insulating glass cover.

7. Microactuator based on bimagnetic coated core/shell microwires with asymmetric external shell according to anyone of claims 1 to 6, wherein the internal metallic magnetostrictive core is formed by a metallic ferromagnetic alloy and has a relevant dimension ranging from 0.6 to 30 µm.

8. Microactuator based on bimagnetic coated core/shell microwires with asymmetric external shell according to claim 7, wherein the metallic ferromagnetic alloy has amorphous structure and comprises:
- 65% to 85% in atomic percentage of magnetogen elements selected from Fe, Co and Ni and combinations thereof,
- 15% to 35% in atomic percentage of metalloid elements selected from Si, B and C.

9. Microactuator based on bimagnetic coated core/shell microwires with asymmetric external shell according to claim 8, wherein the metallic ferromagnetic alloy additionally comprises other non-magnetic elements selected from Al, Cu, Nb, Mn, Cr, Mo and combinations thereof in an amount less than 5% in atomic percentage to keep the amorphous structure of the alloy.

10. Microactuator based on bimagnetic coated core/shell microwires with asymmetric external shell according to anyone of claims 6 to 9, wherein the insulating glass cover has a thickness ranging from 2 µm to 30 µm.

11. Microactuator based on bimagnetic coated core/shell microwires with asymmetric external shell according to anyone of claims 1 to 10, wherein the external coating metallic magnetostrictive shell is formed by a metallic ferromagnetic alloy and has a thickness ranging from 0.03 to 5 µm.

12. Microactuator based on bimagnetic coating core/shell microwires with asymmetric external shell according to claim 11 wherein the external coating metallic magnetostrictive shell covers the internal core in a range from 20% to 80% of its outer surface.

13. Microactuator based on bimagnetic coating core/shell microwires with asymmetric external shell according to claims 11 and 12, wherein the metallic ferromagnetic alloy of the external coating metallic magnetostrictive shell comprises magnetogen elements selected from Fe, Co and Ni and combinations thereof.

14. Microactuator based on bimagnetic coating core/shell microwires with asymmetric external shell according to claim 13, wherein the external coating metallic magnetostrictive shell is a metallic alloy based on CoFe elements.

15. Microactuator based on bimagnetic coating core/shell microwires with asymmetric external shell according to anyone of claims 1 to 5, wherein a metallic nanolayer is located on the internal metallic magnetostrictive core, whereon the external coating metallic magnetostrictive shell is deposited.

16. Microactuator based on bimagnetic coating core/shell microwires with asymmetric external shell according to anyone of claims 6 to 14, wherein a metallic nanolayer is located on the insulating glass cover whereon the external coating metallic magnetostrictive shell is deposited.

17. Microactuator based on bimagnetic coating core/shell microwires with asymmetric external shell according to claims 15 or 16, wherein the metallic nanolayer is a noble metal nanolayer.

18. Use of a microactuator based on bimagnetic coated core/shell microwires with asymmetric external shell as defined in claims 1 to 17 with magnetic objects which includes:
- approaching the microactuator to the magnetic object
- applying an external magnetic field to the active element of the microactuator
- capture of the stray field generated at the end of the active element of the microactuator by the magnetic object
- bending of the active element of the microactuator
- displacement in two or three dimensions of the magnetic objects captured by the stray field at the end of the active element of the microactuator.

19. Use of a microactuator based on bimagnetic coated core/shell microwires with asymmetric external shell as defined in claims 1 to 17 with non magnetic objects which includes:
- contacting the microactuator with the non magnetic object
- applying an external magnetic field to the active element of the microactuator
- bending of the active element of the microactuator
- mechanical displacement in two or three dimensions of the non magnetic object.

## Patentansprüche

1. Mikroaktuator auf Basis von bimagnetischen beschichteten Kern/Hülle-Mikrodrähten, **dadurch gekennzeichnet, dass** er eine asymmetrische äußere Hülle mit mindestens einem eindimensionalen aktiven Verbundelement umfasst, das Folgendes umfasst:
- einen inneren magnetostriktiven Metallkern
- eine äußere beschichtende magnetostriktive Metallhülle
wobei die Materialien des inneren magnetostriktiven Metallkerns und der äußeren beschichtenden magnetostriktiven Metallhülle entweder ein entgegengesetztes Magnetostriktionszeichen oder dasselbe Magnetostriktionszeichen mit unterschiedlichen Werten des jeweiligen Magnetostriktionskoeffizienten aufweisen,
und wobei die äußere beschichtende magnetorestriktive Metallhülle den inneren Kern nur teilweise asymmetrisch abdeckt.

2. Mikroaktuator auf Basis von beschichteten Kern/Hülle-Mikrodrähten mit asymmetrischer äußerer Hülle nach Anspruch 1, wobei die Materialien des inneren magnetostriktiven Metallkerns und der äußeren beschichtenden magnetostriktiven Metallhülle das gleiche Magnetostriktionszeichen mit Werten des jeweiligen Magnetostriktionskoeffizienten aufweisen, die sich um mindestens den Faktor 10 unterscheiden.

3. Mikroaktuator auf Basis von beschichteten Kern/Hülle-Mikrodrähten mit asymmetrischer äußerer Hülle nach Anspruch 2, wobei die Materialien des inneren magnetostriktiven Metallkerns und der äußeren beschichtenden magnetostriktiven Metallhülle das gleiche Magnetostriktionszeichen mit Magnetostriktionskoeffizientenwerten aufweisen, die sich um einen Faktor im Bereich von 10 bis 1000 unterscheiden.

4. Mikroaktuator auf Basis von beschichteten Kern/Hülle-Mikrodrähten mit asymmetrischer äußerer Hülle nach einem der Ansprüche 1 und 3, wobei das mindestens eine eindimensionale aktive Verbundelement eine geometrische Konfiguration aufweist, die ausgewählt ist aus zylindrisch, kugelförmig und ellipsoid.

5. Mikroaktuator auf Basis von beschichteten Kern/Hülle-Mikrodrähten mit asymmetrischer äußerer Hülle nach Anspruch 4, wobei das mindestens eine eindimensionale aktive Verbundelement zylindrisch ist und die äußere beschichtende magnetostriktive Metallhülle den inneren Kern konzentrisch und asymmetrisch nur teilweise abdeckt.

6. Mikroaktuator auf der Basis von bimagnetischen beschichteten Kern/Hülle-Mikrodrähten mit asymmetrischer äußerer Hülle nach einem der Ansprüche 1 bis 5, wobei der innere magnetorestriktive Metallkern mit einer isolierenden Glasabdeckung beschichtet ist und die äußere beschichtende magnetostriktive Metallhülle den inneren magnetostriktiven Metallkern mit der Isolierglasabdeckung nur teilweise asymmetrisch abdeckt.

7. Mikroaktuator auf Basis von bimagnetischen beschichteten Kern/Hülle-Mikrodrähten mit asymmetrischer äußerer Hülle nach einem der Ansprüche 1 bis 6, wobei der innere magnetostriktive Metallkern durch eine ferromagnetische Metalllegierung gebildet ist und eine relevante Abmessung im Bereich von 0,6 bis 30 µm aufweist.

8. Mikroaktuator auf Basis von bimagnetischen beschichteten Kern/Hülle-Mikrodrähten mit asymmetrischer äußerer Hülle nach Anspruch 7, wobei die ferromagnetische Metalllegierung eine amorphe Struktur aufweist und umfasst:
- 65 Atom-% bis 85 Atom-% von aus Fe, Co und Ni ausgewählten Magnetogenelementen und Kombinationen davon,
- 15 Atom-% bis 35 Atom-% von aus Si, B und C ausgewählten Metalloidelementen.

9. Mikroaktuator auf Basis von bimagnetischen beschichteten Kern/Hülle-Mikrodrähten mit asymmetrischer äußerer Hülle nach Anspruch 8, wobei die ferromagnetische Metalllegierung zusätzlich andere nichtmagnetische Elemente umfasst, die ausgewählt sind aus Al, Cu, Nb, Mn, Cr, Mo und Kombinationen davon in einer Menge von weniger als 5 Atom-%, um die amorphe Struktur der Legierung aufrechtzuerhalten.

10. Mikroaktuator auf Basis von bimagnetischen beschichteten Kern/Hülle-Mikrodrähten mit asymmetrischer äußerer Hülle nach einem der Ansprüche 6 bis 9, wobei die Isolierglasabdeckung eine Dicke im Bereich von 2 µm bis 30 µm aufweist.

11. Mikroaktuator auf Basis von bimagnetischen beschichteten Kern/Hülle-Mikrodrähten mit asymmetrischer äußerer Hülle nach einem der Ansprüche 1 bis 10, wobei die externe beschichtende magnetorestriktive Metallhülle aus einer metallischen ferromagnetischen Legierung gebildet ist und eine Dicke im Bereich von 0,03 bis 5 µm aufweist.

12. Mikroaktuator auf Basis von bimagnetischen beschichtenden Kern/Hülle-Mikrodrähten mit asymmetrischer äußerer Hülle nach Anspruch 11, wobei die externe beschichtende magnetorestriktive Metallhülle den inneren Kern in einem Bereich von 20 % bis 80 % seiner Außenfläche abdeckt.

13. Mikroaktuator auf Basis von bimagnetischen beschichtenden Kern/Hülle-Mikrodrähten mit asymmetrischer äußerer Hülle nach Anspruch 11 und 12, wobei die ferromagnetische Metalllegierung der magnetostriktiven Metallhülle eine Magnetogenelementschicht umfasst, die ausgewählt ist aus Fe, Co und Ni und Kombinationen davon.

14. Mikroaktuator auf Basis von bimagnetischen beschichtenden Kern/Hülle-Mikrodrähten mit asymmetrischer äußerer Hülle nach Anspruch 13, wobei die externe beschichtende magnetorestriktive Metallhülle eine Metalllegierung ist, die auf CoFe-Elementen basiert.

15. Mikroaktuator auf Basis von bimagnetischen beschichtenden Kern/Hülle-Mikrodrähten mit asymmetrischer äußerer Hülle nach einem der Ansprüche 1 bis 5, wobei sich eine metallische Nanoschicht auf dem inneren magnetostriktiven Metallkern befindet, auf dem die externe beschichtende magnetorestriktive Metallhülle abgeschieden ist.

16. Mikroaktuator auf Basis von bimagnetischen beschichtenden Kern/Hülle-Mikrodrähten mit asymmetrischer äußerer Hülle nach einem der Ansprüche 6 bis 14, wobei sich eine metallische Nanoschicht auf der Isolierglasabdeckung befindet, auf der die externe beschichtende magnetorestriktive Metallhülle abgeschieden ist.

17. Mikroaktuator auf Basis von bimagnetischen beschichtenden Kern/Hülle-Mikrodrähten mit asymmetrischer äußerer Hülle nach Anspruch 15 oder 16, wobei die metallische Nanoschicht eine Edelmetallnanoschicht ist.

18. Verwendung eines Mikroaktuators auf der Basis von bimagnetischen beschichteten Kern/Hülle-Mikrodrähten mit asymmetrischer äußerer Hülle nach Anspruch 1 bis 17 mit magnetischen Objekten, die einschließt:
- Annähern des Mikroaktuators an das magnetische Objekt
- Anlegen eines externen Magnetfelds an das aktive Element des Mikroaktuators
- Erfassen des Streufeldes, das am Ende des aktiven Elements des Mikroaktuators vom magnetischen Objekt erzeugt wird
- Biegen des aktiven Elements des Mikroaktuators
- Verschiebung der vom Streufeld am Ende des aktiven Elements des Mikroaktuators erfassten magnetischen Objekte in zwei oder drei Dimensionen.

19. Verwendung eines Mikroaktuators auf der Basis von bimagnetischen beschichteten Kern/Hülle-Mikrodrähten mit asymmetrischer äußerer Hülle nach Anspruch 1 bis 17 mit nicht magnetischen Objekten, die einschließt:
- Inkontaktbringen des Mikroaktuators mit dem nicht magnetischen Objekt
- Anlegen eines externen Magnetfelds an das aktive Element des Mikroaktuators
- Biegen des aktiven Elements des Mikroaktuators
- mechanische Verschiebung des nicht magnetischen Objekts in zwei oder drei Dimensionen.

## Revendications

1. Microactionneur à base de microfils cœur/écorce revêtus bimagnétiques **caractérisé en ce qu'**il comprend une écorce externe asymétrique ayant, au moins, un élément actif unidimensionnel composé qui comprend :
- un cœur magnétostrictif métallique interne
- une écorce magnétostrictive métallique de revêtement externe les matériaux dudit cœur magnétostrictif métallique interne et de ladite écorce magnétostrictive métallique de revêtement externe présentant soit un signe de magnétostriction opposé soit le même signe de magnétostriction avec des valeurs différentes du coefficient de magnétostriction respectif,
et dans lequel l'écorce magnétostrictive métallique de revêtement externe ne recouvre asymétriquement qu'une partie seulement du cœur interne.

2. Microactionneur à base de microfils cœur/écorce revêtus avec une écorce externe asymétrique, selon la revendication 1, dans lequel les matériaux du cœur magnétostrictif métallique interne et de l'écorce magnétostrictive métallique de revêtement externe ont le même signe de magnétostriction avec des valeurs du coefficient de magnétostriction respectif qui diffèrent d'au moins un facteur de 10.

3. Microactionneur à base de microfils cœur/écorce revêtus avec une écorce externe asymétrique, selon la revendication 2, dans lequel les matériaux du cœur magnétostrictif métallique interne et de l'écorce magnétostrictive métallique de revêtement externe ont le même signe de magnétostriction avec des valeurs de coefficient de magnétostriction différentes dans un facteur allant de 10 à 1000.

4. Microactionneur à base de microfils cœur/écorce revêtus avec une écorce externe asymétrique, selon l'une quelconque des revendications 1 et 3, dans lequel, au moins, un élément actif unidimensionnel composé présente une configuration géométrique choisie entre cylindrique, sphéroïdale et ellipsoïdale.

5. Microactionneur à base de microfils cœur/écorce revêtus avec une écorce externe asymétrique, selon la revendication 4, dans lequel, au moins, un élément actif unidimensionnel composé est cylindrique et l'écorce magnétostrictive métallique de revêtement externe recouvre concentriquement et asymétriquement seulement partiellement le cœur interne.

6. Microactionneur à base de microfils cœur/écorce revêtus bimagnétiques avec une écorce externe asymétrique, selon l'une quelconque des revendications 1 à 5, dans lequel le cœur magnétostrictif métallique interne est revêtu d'un revêtement en verre isolant et l'écorce magnétostrictive métallique de revêtement externe ne recouvre que partiellement, asymétriquement le cœur magnétostrictif métallique interne avec le revêtement en verre isolant.

7. Microactionneur à base de microfils cœur/écorce revêtus bimagnétiques avec une écorce externe asymétrique, selon l'une quelconque des revendications 1 à 6, dans lequel le cœur magnétostrictif métallique interne est formé par un alliage ferromagnétique métallique et présente une dimension pertinente allant de 0,6 à 30 µm.

8. Microactionneur à base de microfils cœur/écorce revêtus bimagnétiques avec une écorce externe asymétrique, selon la revendication 7, dans lequel l'alliage ferromagnétique métallique a une structure amorphe et comprend :
- 65 % à 85 % en pourcentage atomique d'éléments magnétogènes choisis parmi Fe, Co et Ni et leurs combinaisons,
- 15 % à 35 % en pourcentage atomique d'éléments métalloïdes choisis parmi Si, B et C.

9. Microactionneur à base de microfils cœur/écorce revêtus bimagnétiques avec une écorce externe asymétrique, selon la revendication 8, dans lequel l'alliage ferromagnétique métallique comprend, en outre, d'autres éléments non magnétiques choisis parmi Al, Cu, Nb, Mn, Cr, Mo et leurs combinaisons, pour une quantité inférieure à 5 % en pourcentage atomique pour maintenir la structure amorphe de l'alliage.

10. Microactionneur à base de microfils cœur/écorce revêtus bimagnétiques avec une écorce externe asymétrique, selon l'une quelconque des revendications 6 à 9, dans lequel le revêtement en verre isolant a une épaisseur allant de 2 µm à 30 µm.

11. Microactionneur à base de microfils cœur/écorce revêtus bimagnétiques avec une écorce externe asymétrique, selon l'une quelconque des revendications 1 à 10, dans lequel l'écorce magnétostrictive métallique externe de revêtement est formée par un alliage ferromagnétique métallique et présente une épaisseur pertinente allant de 0,03 à 5 µm.

12. Microactionneur à base de microfils cœur/écorce revêtus bimagnétiques avec une écorce externe asymétrique, selon la revendication 11, dans lequel l'écorce magnétostrictive métallique externe de revêtement recouvre le cœur interne dans une plage de 20 % à 80 % de sa surface externe.

13. Microactionneur à base de microfils cœur/écorce revêtus bimagnétiques avec une écorce externe asymétrique, selon les revendications 11 et 12, dans lequel l'alliage ferromagnétique métallique de l'écorce magnétostrictive métallique externe de revêtement comprend des éléments magnétogènes choisis parmi Fe, Co et Ni et des combinaisons de ceux-ci.

14. Microactionneur à base de microfils cœur/écorce revêtus bimagnétiques avec une écorce externe asymétrique, selon la revendication 13, dans lequel l'écorce magnétostrictive métallique externe de revêtement est un alliage métallique à base d'éléments en CoFe.

15. Microactionneur à base de microfils cœur/écorce revêtus bimagnétiques avec une écorce externe asymétrique, selon l'une quelconque des revendications 1 à 5, dans lequel une couche nanométrique métallique est située sur le cœur magnétostrictif métallique interne, sur lequel l'écorce magnétostrictive métallique externe de revêtement est déposée.

16. Microactionneur à base de microfils cœur/écorce revêtus bimagnétiques avec une écorce externe asymétrique, selon l'une quelconque des revendications 6 à 14, dans lequel une couche nanométrique métallique est située sur le revêtement de verre isolant sur lequel l'écorce magnétostrictive métallique de revêtement externe est déposée.

17. Microactionneur à base de microfils cœur/écorce revêtus bimagnétiques avec une écorce externe asymétrique, selon la revendication 15 ou 16, dans lequel la couche nanométrique métallique est une couche nanométrique en métal noble.

18. Utilisation d'un microactionneur à base de microfils cœur/écorce revêtus bimagnétiques avec une écorce externe asymétrique telle que définie dans les revendications 1 à 17 avec des objets magnétiques incluant :
- approcher le microactionneur à l'objet magnétique
- appliquer un champ magnétique externe à l'élément actif du microactionneur
- capturer le champ parasite généré à l'extrémité de l'élément actif du microactionneur par l'objet magnétique
- courber l'élément actif du microactionneur
- déplacer dans deux ou trois dimensions les objets magnétiques capturés par le champ parasite à l'extrémité de l'élément actif du microactionneur.

19. Utilisation d'un microactionneur à base de microfils cœur/écorce revêtus bimagnétiques avec une écorce externe asymétrique, telle que définie dans les revendications 1 à 17, avec des objets non magnétiques incluant :
- contacter le microactionneur avec l'objet non magnétique
- appliquer un champ magnétique externe à l'élément actif du microactionneur
- courber l'élément actif du microactionneur
- déplacer mécaniquement, dans deux ou trois dimensions, l'objet non magnétique.
